(19) Europäisches Patentamt
European Patent Office
Office européen des brevets

(11) EP 3 620 246 B1

(12) EUROPEAN PATENT SPECIFICATION

(45) Date of publication and mention
of the grant of the patent:
**12.07.2023 Bulletin 2023/28**

(51) International Patent Classification (IPC):
**B22F 7/00** (2006.01)   **F28D 15/02** (2006.01)
**F28D 15/04** (2006.01)   **F28F 13/00** (2006.01)
**F28F 13/18** (2006.01)   **F28F 21/08** (2006.01)
**H01L 23/427** (2006.01)   **H05K 7/20** (2006.01)

(21) Application number: **19192694.8**

(22) Date of filing: **20.08.2019**

(52) Cooperative Patent Classification (CPC):
**F24D 10/00; B22F 3/1121; B22F 7/002; B22F 7/08;
F24D 10/003; F28D 15/0266; F28D 15/043;
F28F 13/003; F28F 13/187; F28F 21/085;
F28F 21/089; H01L 23/427; H05K 7/20309;**
F24D 2200/12; Y02B 30/17;                    (Cont.)

(54) **METHOD FOR PRODUCING AN EVAPORATOR**

HERSTELLUNGSVERFAHREN FÜR EINEN VERDAMPFER

PROCÉDÉ DE PRODUCTION D'UN ÉVAPORATEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.09.2018 JP 2018168230**

(43) Date of publication of application:
**11.03.2020 Bulletin 2020/11**

(73) Proprietor: **TOYOTA JIDOSHA KABUSHIKI
KAISHA
Toyota-shi, Aichi-ken 471-8571 (JP)**

(72) Inventors:
• **HIRONO, Shinsuke**
  **Aichi-ken 471-8571 (JP)**
• **HOSHINO, Yu**
  **Aichi-ken 471-8571 (JP)**
• **WATANABE, Masao**
  **Aichi-ken 471-8571 (JP)**
• **YAMASHITA, Seiji**
  **Aichi-ken 471-8571 (JP)**
• **KINOSHITA, Yohei**
  **Aichi-ken 471-8571 (JP)**

(74) Representative: **J A Kemp LLP
80 Turnmill Street
London EC1M 5QU (GB)**

(56) References cited:
WO-A1-97/14925          JP-A- 2000 049 266
JP-A- 2003 293 166      US-A- 3 384 154
US-A- 3 753 757         US-A1- 2009 269 521
US-A1- 2018 128 554

(52) Cooperative Patent Classification (CPC): (Cont.)
Y02P 80/14

**Description**

FIELD

The present disclosure relates to a production method for an evaporator.

BACKGROUND

Heat pipes as devices for transporting heat using the phase changes of a working fluid are known. As an example of a heat pipe, there is a loop-type heat pipe in which an evaporator, a steam pipe, a condenser, and a liquid pipe are connected to form a loop. The term "pipe" does not refer to only cylindrical tubular members but also refers to members having at least one part that is plate-like or box-like.

Conventionally, a porous metal film is provided on the inner wall of an evaporator. Working fluid is transported into this porous metal film and is heated, boiled, and vaporized by a heat source or the like present outside of the evaporator. Thus, the heat exchange performance of the evaporator is greatly influenced by the heat transfer coefficient of the porous metal film provided on the inner wall of the evaporator.

To date, many developments regarding porous metal films have been reported as follows.

For example, Patent Literature 1 discloses a boiling cooler comprising a porous metal sintered body. This porous metal sintered body has a porosity of 50% or more, and pore sizes in the range of 10 to 100 $\mu$m. Furthermore, this porous metal sintered body is joined to a heat receiving wall of the boiling cooler by brazing or soldering.

Patent Literature 2 discloses a porous oxide film formed by depositing an ultrafine particle material by a gas deposition method. The raw material ultrafine particle material has a particle size of 10 nm to 3 $\mu$m and a particle size distribution in the range of 0.2M to 3M with respect to a median particle diameter M.

Patent Literature 3 discloses a method for producing a porous valve metal film, comprising the steps of (1) producing, by mechanical alloying, an alloy powder composed of a valve metal and a heterophasic component which is not compatible with the valve metal, (2) spraying the alloy powder onto at least one surface of a valve metal foil current collector by an impact solidification method, (3) forming a mixed film of the valve metal and the heterophasic component, (4) subjecting the obtained mixed film to a heat treatment, and (5) forming a porous valve metal layer on the valve metal foil current collector by removing the heterophasic component in the mixed film.

Patent Literature 4 discloses a semiconductor module comprising a heat sink composed of a material having a high heat transfer coefficient, and an insulating substrate which has a semiconductor element placed on one surface side thereof and which is impregnated into the heat sink to a predetermined depth on the other surface side. The insulating substrate comprises a porous layer composed of a porous material. Furthermore, the porous layer is impregnated with the heat sink by heating the porous layer to 1100 °C, applying a pressure of 1 t/cm$^2$ thereto, and casting molten copper.

[CITATION LIST]

[PATENT LITERATURE]

[PTL 1] Japanese Unexamined Patent Publication (Kokai) No. 2000-049266
[PTL 2] Japanese Unexamined Patent Publication (Kokai) No. 2003-208901
[PTL 3] Japanese Unexamined Patent Publication (Kokai) No. 2011-044653
[PTL 4] Japanese Unexamined Patent Publication (Kokai) No. 2002-118195

JP 2003 293166 A discloses a tube having grooves on the inner face, which exhibits improved evaporation performance without lowering condensation performance at the inner surface of the tube, and a copper or copper alloy tube suitable as a boiling type heat transfer tube, which exhibits improved evaporation performance at the outer surface in a cooling medium having a low surface tension such as a solution of a chlorofluorocarbon, and methods for producing them. A copper oxide layer is formed on the surface of a tube body made of copper or the copper alloy by a wet or dry chemical conversion treatment. The copper oxide layer has projected parts, each of which has a cross sectional area at its top part smaller than that at its root part. Then, an inorganic film of an amorphous ceramic is formed on the copper oxide layer so that the top parts of the projected parts are exposed. Further, the projected parts exposed from the inorganic film are each dissolved up to the level lower than the surface of the inorganic film. Thereby, pores, each being an entrant cavity having a cross sectional area at an inner part higher than that at the opening part, are formed in the inorganic film.

US 3 753 757 A discloses a method of coating metal substrates with a porous metal layer, comprising the steps of: providing a metal substrate to be porous metal coated; applying a liquid binder solution comprising at least one high volatility solvent component and at least one low volatility component in a layer from 0.002 to 0.040 inch thick onto said metal substrate; applying a 0.005 to 0.050 inch thick layer of metal powder 30-500 mesh size onto the binder layer so that the binder layer wets the metal powder coating and retains it against said metal substrate; evaporating substantially all of the high volatility component of said liquid binder solution; heating the metal powder coated metal substrate to temperature sufficient to evaporate substantially all of the binder low volatility component; further heating the metal powder coated metal substrate to temperature sufficient to bond the metal powder to itself and to the metal substrate so as to form a porous metal layer having interconnected surface and subsurface cavities; and cooling the porous metal layer bonded metal substrate.

## SUMMARY

The invention is defined in claim 1. Further aspects and preferred embodiments are defined in the dependent claims. Any aspects, embodiments and examples of the present disclosure which do not fall under the scope of the appended claims do not form part of the invention and are merely provided for illustrative purposes.

[TECHNICAL PROBLEM]

In order to realize a high evaporator heat exchange performance, it is necessary to increase the heat transfer coefficient of the porous metal film provided inside the evaporator. Thus, increasing, for example, the heat transfer area of the porous metal film has been considered. Furthermore, in order to increase the heat transfer area of the porous metal film, reducing the diameter of the communication holes in the porous metal film and increasing the porosity have been considered.

However, in the methods disclosed in the prior art documents, commonly the hole diameters of communication holes cannot be made sufficiently small or the porosity cannot be sufficiently increased.

Furthermore, in the method in which a porous metal film is joined with the inner wall of an evaporator by brazing or soldering, there is a risk that brazing material or solder will enter into the pores of the porous metal film. If a heterogeneous phase such as brazing material or solder is present in the communication holes of the porous metal film, there is a problem in that not only will the porosity be reduced, but the phonon scattering of the porous metal film becomes large, which lowers the heat transfer coefficient.

Furthermore, in a method in which a porous metal film is joined with the inner wall of an evaporator by crimping, the larger the porosity of the porous metal film, the more likely that the voids of the porous metal film will be crushed by the crimping, decreasing the heat transfer coefficient. Though methods in which the porous metal film is not bonded to the inner wall of the evaporator have been considered, in such a case, the thermal resistance at the interface between the porous metal film and the inner wall of the evaporator becomes large, whereby the temperature of the porous metal film decreases. As a result, there is a problem in that it is difficult for the fluid to boil or vaporize, whereby heat can be dissipated only in low heat flux regions.

Since the heat transfer coefficients of porous metal films reported to date are commonly insufficient, there is still room for improvement in the heat exchange performance of evaporators.

Thus, in light of the circumstances described above, the present disclosure aims to provide an evaporator having improved heat exchange performance, a production method therefor, and a loop-type heat pipe comprising an evaporator.

[SOLUTION TO PROBLEM]

The inventors of the present disclosure have discovered that the above problems can be solved by the following means.

<Aspect 1>

A method for producing an evaporator comprising a metal wall and a porous metal film which is directly connected to the metal wall, the method comprising the steps of:

   (a) simultaneously spraying an aerosol comprising metal particles from a nozzle and an aerosol comprising pore-forming-material particles from another nozzle onto a metal substrate to form a composite film on the metal substrate, and
   (b) firing the composite film to form the porous metal film.

<Aspect 2>

The method according to Aspect 1, wherein the pore-forming-material particles are dielectric particles having electrification characteristics.

<Aspect 3>

The method according to Aspect 1 or 2, wherein the metal particles are copper particles.

<Aspect 4>

The method according to any one of Aspects 1 to 3, wherein the pore-forming-material particles are polymethyl methacrylate particles.

[ADVANTAGEOUS EFFECTS OF INVENTION]

According to the present disclosure, the heat exchange performance of an evaporator can be improved.

BRIEF DESCRIPTION OF DRAWINGS

FIG. 1 is a cross-sectional view showing an evaporator of the present disclosure.
FIG. 2 is an image captured using a scanning electron microscope (SEM) showing a porous metal film according to the present disclosure.
FIG. 3 is a pattern diagram showing an embodiment of step (a) according to the present disclosure.
FIG. 4 is an image showing the mechanism for the formation of a composite film according to the present disclosure.
FIG. 5 is a perspective view showing a loop-type heat pipe of the present disclosure.
FIG. 6 is an image showing an evaluation model of the Examples and the Comparative Examples.
FIG. 7 is an image of the cross-sections of the porous metal film and metal wall of Example 1 captured using a scanning electron microscope (SEM).
FIG. 8 is an image of the surface of the porous metal film of Example 1 captured using a scanning electron microscope (SEM).

DESCRIPTION OF EMBODIMENTS

The embodiments of the present disclosure will be described in detail below while referring to the drawings. Note that for convenience of explanation, in the drawings, identical or corresponding portions have been assigned the same reference numerals and duplicate explanations thereof have been omitted. Not all of the constituent elements of the embodiments are necessarily indispensable, and some of the constituent elements may be omitted in some cases. The embodiments shown in the drawings below are merely examples of the present disclosure. The present disclosure is not limited thereto.

<<Evaporator>>

The evaporator of the present disclosure comprises a metal wall and a porous metal film directly connected to the metal wall without heating and melting,
wherein the porous metal film has communication holes having an average pore size of 8 $\mu$m or less, and the porous metal film has a porosity of 50% or more.

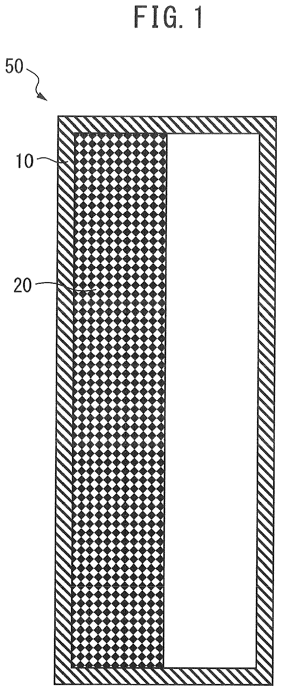

FIG. 1 is a cross-sectional view showing an evaporator of the present disclosure. The evaporator 50 of the present disclosure comprises a metal wall 10, and a porous metal film 20 directly connected to the metal wall. Note that the porous metal film 20 has communication holes having an average pore size of 8 $\mu$m or less, and has a porosity of 50% or more.

<Porous Metal Film>

The porous metal film of the present disclosure is directly connected to the metal wall of the evaporator, has communication holes having an average pore size of 8 $\mu$m or less, and has a porosity of 50% or more.

Since the porous metal film is directly connected to the metal wall, no heterogeneous phase material such as a bonding material is present in the interface between the metal wall and the porous metal film. As a result, phonon scattering of the porous metal film can be prevented, whereby thermal resistance can be reduced.

Furthermore, since the porous metal film has communication holes having an average pore size of 8 μm or less, and has a porosity of 50% or more, the heat transfer area of the porous metal film can be significantly increased, and thus, a high heat transfer coefficient can be imparted to the porous metal film.

The evaporator of the present disclosure, which comprises such a porous metal film, can achieve a high heat performance.

Note that in the present disclosure, "directly connect" means that the metal wall and the porous metal film to be joined are directly bonded, and indicates a state in which bonding material such as solder is not present in the interface between the metal wall and the porous metal film.

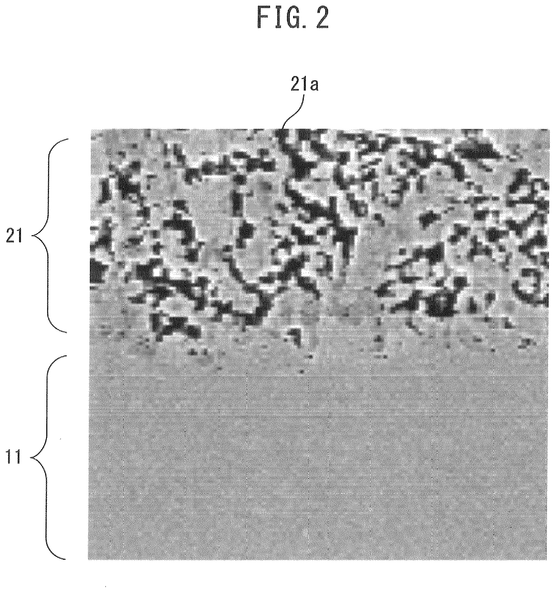

FIG. 2 is an image captured using a scanning electron microscope (SEM) showing the porous metal film according to the present disclosure. The porous metal film 21 is directly connected to the metal wall 11. The porous metal film 21 comprises a plurality of communication holes, for example, the communication holes 21a, having an average pore size of 8 μm or less. Furthermore, the porous metal film 21 has a porosity of 50% or more.

(Communication Holes)

In the present disclosure, "communication holes" are pores which communicate with the surfaces of the porous metal film.

The average pore size of the communication holes of the present disclosure is not particularly limited as long as it is 8 μm or less. For example, the average pore size of the communication holes may be 7 μm or less, 6 μm or less, 5 μm or less, 4 μm or less, 3 μm or less, 2 μm or less, or 1 μm or less, and may be 0.5 μm or more, 1 μm or more, 2 μm or more, 3 μm or more, 4 μm or more, or 5 μm or more.

The average pore size of the communication holes can be controlled to within the range of the present disclosure by appropriately adjusting the average particle diameter of the pore-forming-material particles used in step (a), which will be described later, and/or the firing conditions of step (b).

Furthermore, the average pore size can be determined by the porosimeter method demonstrated in the Examples.

More specifically, using a porosimeter, water is injected into the pores of the communication holes of the porous metal film, and the pressure imparted to the water and the weight of the water injected into the pores by means of this pressure are measured.

The volume of the water can be determined from the weight of the water injected into the pores. The volume of water determined in this manner is equal to the volume of the communication holes. The pressure imparted to the water and the pore size of the communication holes satisfy the following Formula (1) (Washburn's equation):

$$D = -4\sigma\cos\theta/P \quad (1)$$

wherein D represents the pore size (diameter) of the communication holes, σ represents the surface tension of water, θ represents the contact angle between the water and the surface of the communication holes, and P represents the pressure imparted to the water.

The volume of water injected into the communication holes is determined for each pressure p1, p2, ..., and pi. Furthermore, the pore sizes for each pressure are determined from Formula (1). The volume average pore size mv of the communication holes is determined from Formula (2) below using the determined volumes v1, v2, ..., and vi of water and the determined pore sizes d1, d2, ..., and di for each pressure p1, p2, ..., and pi. The value of the volume average pore size mv of the communication holes is referred to as the "average pore size of the communication holes" in the present disclosure.

$$mv = (v1 \cdot d1 + v2 \cdot d2 + ... + vi \cdot di) / (v1 + v2 + ... + vi) = \{\sum(vi \cdot di)\} / \{\sum(vi)\} \quad (2)$$

(Porosity)

The porosity of the porous metal film is not particularly limited as long as it is 50% or more. For example, the porosity may be 55% or more, 60% or more, 65% or more, 70% or more, 75% or more, or 80% or more. Furthermore, the upper limit of the porosity is not particularly limited and may be, from the viewpoint of maintaining the strength of the porous metal film, 90% or less, 85% or less, 80% or less, 75% or less, or 70% or less.

The porosity of the porous metal film can be controlled to within the range of the present disclosure by appropriately adjusting the weight ratio (or mass ratio) of the metal particles to the pore-forming-material particles used in step (a), which will be described later, the average particle diameter of the pore-forming-material particles, and/or the firing conditions of step (b).

Furthermore, the porosity can be determined by the method demonstrated in the Examples.

More specifically, the porosity of the porous metal film is determined using Formula (3) below by measuring the bulk volume of the porous metal film and combining with the volume of the water injected into the communication holes.

$$Po = Vtot / Vb \ (3)$$

wherein Po represents the porosity of the porous metal film, Vtot represents the volume of injected water, and Vb represents the bulk volume of the porous metal film. Furthermore, Vb = Vp - Vm - Vs, wherein Vp represents the cell volume, Vm represents the volume of water entering the cells housing the porous metal film when no pressure is applied, and Vs represents the volume of the metal substrate (metal wall).

(Material of Porous Metal Film)

Examples of the material of the porous metal film include metal particles of, for example, copper, aluminum, or silver. However, the material of the porous metal film is not limited thereto. Among these, from the viewpoint of improving the heat transfer coefficient, copper particles are preferably used. In other words, the porous metal film is preferably a coppercontaining porous metal film.

(Skeleton)

The skeleton of the porous metal film refers to the portion of the porous metal film excluding the communication holes. The skeleton of the porous metal film may be constituted by firing the metal particles which are the material of the porous metal film.

Furthermore, the skeleton of the porous metal film preferably has a concave-convex structure. The "concave-convex structure" may be formed by connecting the metal particles to each other. If such a concave-convex structure is included, when working fluid is boiled in the pores, nucleate boiling can be promoted. As a result, a higher heat transfer coefficient can be imparted to the porous metal film.

Nano-sized communication holes may be present in the concave-convex structure. The average pore size of nano-sized communication holes may be, for example, 500 nm or less, 400 nm or less, 300 nm or less, 200 nm or less, or 100 nm or less.

Furthermore, the present or absence of a concave-convex structure in the skeleton of the porous metal film can be controlled by, for example, adjusting the firing temperature of step (b), which is described later.

(Film Thickness)

The film thickness of the porous metal film is not particularly limited. From the viewpoint of preventing heat pressure loss (friction loss) relative to the thickness of the porous metal film, the film thickness may be 500 $\mu$m or less, 450 $\mu$m or less, 400 $\mu$m or less, 350 $\mu$m or less, 300 $\mu$m or less, 250 $\mu$m or less, 200 $\mu$m or less, 150 $\mu$m or less, 120 $\mu$m or less, or 100 $\mu$m or less. Furthermore, from the viewpoint of ensuring the heat transfer area of the porous metal film, the film thickness may be 20 $\mu$m or more, 35 $\mu$m or more, 50 $\mu$m or more, 75 $\mu$m or more, or 100 $\mu$m or more.

Note that in the present disclosure, the film thickness (or thickness) can be measured using a contact-type film thickness meter. More specifically, the film thickness is measured at arbitrary five locations on the surface of the same film, and the arithmetic mean value thereof can be obtained as the film thickness. Furthermore, the film thickness of the porous metal film can be determined as the value obtained by subtracting the thickness of the metal wall from the total film thickness of the metal wall and the porous metal film directly connected to the metal wall.

<Metal Wall>

The metal wall can be formed from a metal plate. Furthermore, the metal wall can be formed from a metal plate including a coating or plating on a surface thereof. From the viewpoint of heat conduction, it is preferable that a coating or plating not be included.

Furthermore, the metals which can be used in the metal wall are not particularly limited and may be, for example, copper, aluminum, or iron, or may be mixtures or alloys thereof.

Note that it is only necessary that a metal wall to which the porous metal film is directly connected be included on at least one surface of the evaporator of the present disclosure. It is not necessary that metal wall be included on all of the surfaces of the inner wall of the evaporator.

Furthermore, in the evaporator of the present disclosure, another porous metal film may be further disposed on the surface of the side opposite the metal wall of the porous metal film.

<<Evaporator Production Method>>

The present disclosure further provides a method for producing an evaporator comprising a metal wall and a porous metal film directly connected to the metal wall.

The method of the present disclosure comprises the following steps of:

(a) simultaneously spraying an aerosol comprising metal particles from a nozzle and an aerosol comprising pore-forming-material particles from another nozzle onto a metal substrate to form a composite film on the metal substrate, and

(b) firing the composite film to form the porous metal film.

The evaporator produced by the method of the present disclosure comprises a metal wall and a porous metal film directly connected to the metal wall. The porous metal film has communication holes having an average pore size of 8 $\mu$m or less, and may have a porosity of 50% or more. Regarding the details of the evaporator, refer to the description in the section

<<Evaporator>> above. An explanation thereof has been omitted.

According to the method of the present disclosure, the porous metal film can be directly connected to the metal substrate without heating and melting, and thus, both a small pore size and a high porosity can be achieved.

<Step (a)>

In step (a), a first aerosol comprising metal particles from a nozzle and a second aerosol comprising pore-forming-material particles from another nozzle are simultaneously sprayed onto a metal substrate to form a composite film on the metal substrate.

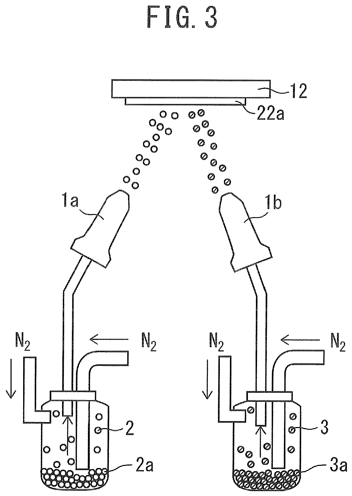

FIG. 3 is a pattern diagram showing an embodiment of step (a) according to the present disclosure. More specifically, FIG. 3 shows an aspect in which a first aerosol 2a comprising metal particles 2 from a nozzle 1a and a second aerosol 3a comprising pore-forming-material particles 3 from a nozzle 1b are simultaneously sprayed onto a metal substrate 12 to form a composite film 22a on the metal substrate 12.

In the present disclosure, "aerosol" means a mixture of a carrier gas and raw material particles for film-forming. For example, the first aerosol is a mixture of a carrier gas and metal particles, and the second aerosol is a mixture of a carrier gas and pore-forming-material particles.

Furthermore, the carrier gas is not particularly limited, and may be, for example, an inert gas such as nitrogen gas, argon gas, or helium gas. Note that the carrier gas included in the first aerosol and the carrier gas included in the second aerosol may be the same or may be different.

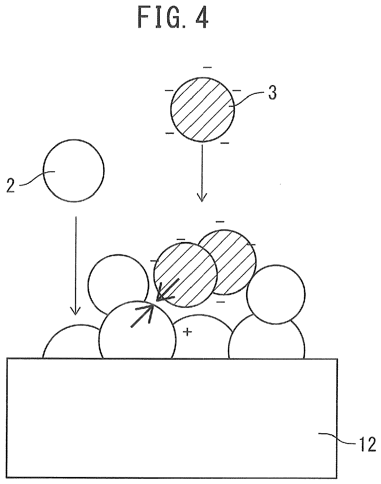

In step (a), it is inferred that the composite film forms as in, for example, the formation mechanism image shown in FIG. 4. In other words, it is possible to impart a negative charge to the pore-forming-material particles 3 included in the sprayed second aerosol by means of collision. Simultaneously, the metal particles 2 included in the sprayed first aerosol contact the negatively charged pore-forming-material particles 3 on or in the vicinity of the metal substrate 12, and can be positively charged. Thus, the positively charged metal particles 2 and the negatively charged pore-forming-material particles 3 are complexed, whereby a composite film can be formed. On the other hand, when the metal particles 2 arrive on the metal substrate, they elastically deform to form a composite film skeleton. The composite film skeleton formed in this manner is fired, as described later, to produce a porous metal film skeleton. Note that the formation mechanism of the composite film is merely speculative and does not limit the present disclosure.

In step (a), regarding simultaneous spraying, a device which can perform simultaneous spraying, for example, an aerosol gas deposition (AGD) device, can be used.

Furthermore, the particle velocity when simultaneously spraying can be, for example, 400 m/s or less. Conventionally, when an aerosol comprising a single type of metal particles is sprayed under normal temperature conditions, from the viewpoint of ensuring adhesion of the metal particles to the substrate, the particle velocity is often set to 500 m/s or more. However, if the particle velocity is set to 500 m/s or more, when metal particles adhere to the substrate, deformation of the metal particles becomes significant, and there is a risk that a uniform porous metal film cannot be formed.

In connection thereto, in step (a), since the first aerosol and the second aerosol are simultaneously sprayed, the pore-forming material included in the second aerosol can enhance adhesion of the metal particles included in the first aerosol to the metal substrate. As a result, even if the particle velocity is 400 m/s or less, a uniform porous metal film can be formed. Furthermore, from the viewpoint of improving the adhesion efficiency of the particles, the particle velocity at the time of simultaneous spraying is preferably 100 m/s or more.

Regarding the metal particles, refer to the description of the metal particles used in the material of the porous metal film described above. Thereamong, from the viewpoint of improving the heat transfer coefficient, the metal particles are preferably copper particles.

Furthermore, the average particle diameter of the metal particles is not particularly limited. For example, the average particle diameter of the metal particles may be 0.05 $\mu$m or more, 0.10 $\mu$m or more, 0.15 $\mu$m or more, or 0.20 $\mu$m or more, and may be 1.00 $\mu$m or less, 0.80 $\mu$m or less, 0.50 $\mu$m or less, or 0.30 $\mu$m or less.

Note that in the present disclosure, "average particle diameter" means the value (D50) when the cumulative % of the particle size distribution measured by a laser diffraction-type particle size distribution measurement method is 50%. For example, the laser diffraction-type particle size distribution measurement device "SALD 2000" manufactured by Shimadzu Corporation can be used to measure the average particle diameter.

In the present disclosure, "pore-forming-material particles" are a substance which introduce holes into the later-formed porous metal film and which are removed after the composite film is formed from the metal material particles and the pore-forming-material particles.

The pore-forming-material particles may be, for example, dielectric particles having electrification characteristics or may be particles of an insulator. In consideration of the formation mechanism of the composite film described above, the pore-forming-material particles are preferably dielectric particles having electrification characteristics. For example, particles of polymethyl methacrylate (PMMA) or polystyrene particles are preferable. Furthermore, from the viewpoint of ease of handling, the pore-forming-material particles are preferably polymethyl methacrylate particles.

The average particle diameter of the pore-forming-material particles is not particularly limited. For example, the average particle diameter of the pore-forming-material particles may be 0.1 $\mu$m or more, 0.5 $\mu$m or more, 1 $\mu$m or more, 2 $\mu$m or more, 3 $\mu$m or more, 4 $\mu$m or more, 5 $\mu$m or more, 6 $\mu$m or more, 7 $\mu$m or more, or 8 $\mu$m or more, and may be 10 $\mu$m or less, 9 $\mu$m or less, 8 $\mu$m or less, 7 $\mu$m or less, 6 $\mu$m or less, 5 $\mu$m or less, 4 $\mu$m or less, 3 $\mu$m or less, 2 $\mu$m or less, or 1 $\mu$m or less.

Since a composite film is formed in step (a), the amount of the metal particles and pore-forming-material particles used is not particularly limited. These amounts can be appropriately adjusted in accordance with the desired porosity of the porous metal film.

For example, the weight ratio of the metal particles to the pore-forming-material particles (metal particles : pore-forming material) may be 50:50 to 95:5, 60:40 to 90:10, or 70:30 to 85:15.

Furthermore, the volume ratio of the metal particles to the pore-forming-material particles (metal particles: pore-forming material) may be 12:88 to 72:28, 17:83 to 55:45, or 24:76 to 43:57.

<Step (b)>

In step (b), the composite film described above is fired, whereby a porous metal film is formed.

(Firing of Composite Film)

The temperature of firing can be appropriately adjusted in accordance with the type of metal particles used, and may be, for example, 300 °C or more, 320 °C or more, 340 °C or more, 360 °C or more, 380 °C or more, 400 °C or more, 500 °C or more, 550 °C or more, 600 °C or more, 650 °C or more, 680 °C or more, 700 °C or more, 720 °C or more, or 750 °C or more, and may be 1000 °C or less, 900 °C or less, 850 °C or less, 800 °C or less, 780 °C or less, or 750 °C or less. The duration of firing may be several hours to several tens of hours, and can be appropriately adjusted in accordance with the type of metal particles used. Furthermore, the firing may be performed in an inert gas or may be performed in a vacuum.

Furthermore, by adjusting the temperature of firing, the presence or absence of a concave-convex structure in the skeleton of the porous metal film can be controlled. For example, when firing is performed within a certain temperature range, the metal particles partially sinter, whereby such metal particles can be connected to each other to form a concave-convex structure in the skeleton of the porous metal film. If firing is performed at a temperature exceeding this certain range, the sintering of the metal particles further progresses, whereby an established concave-convex structure can be eliminated. Note that the specific temperature range can be appropriately set in accordance with the type of metal particles used.

Furthermore, the method of the present disclosure can further include a step prior to or after step (b) in which removal of the pore-forming-material particles is performed. Alternatively, the pore-forming-material particles can be removed in step (b) as the composite film is fired.

(Removal of Pore-Forming-Material Particles)

Regarding the method for removing the pore forming material, the following method (i) or (ii) can appropriately be used depending on the type of pore-forming material used. However, the method for removing the pore forming material is not limited thereto.

Method (i): Method for Removal by Thermal Decomposition of Pore-Forming-Material Particles

The temperature of thermal decomposition can be appropriately adjusted in accordance with the type of pore-forming material used, and may be, for example, 280 °C or more, 300 °C or more, 330 °C or more, or 350 °C or more. However, the temperature of thermal decomposition is not limited thereto. The duration of thermal decomposition may be several hours to several tens of hours, and can be appropriately adjusted in accordance with the pore-forming material used. Furthermore, thermal decomposition may be performed in an inert gas or may be performed in a vacuum.

In this case, in step (b) described above, the pore-forming-material particles can be decomposed and removed by the firing heat as the composite film is fired.

Method (ii): Method for Removal by Dissolution of Pore-Forming-Material Particles in Organic Solvent

Examples of the organic solvent include acetone, toluene, chloroform, and alcohol. However, the organic solvent is not limited thereto.

<<Loop-Type Heat Pipe>>

The present disclosure can further provide a loop-type heat pipe.

The loop-type heat pipe of the present disclosure comprises an evaporator, a steam pipe, a condenser, and a liquid pipe connected in this order to form a loop.

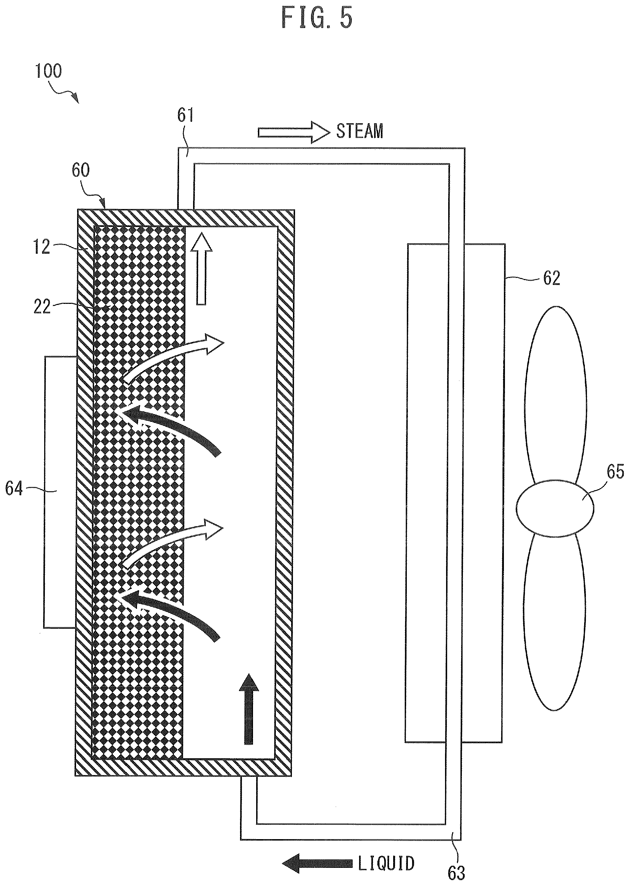

FIG. 5 is a schematic view showing the loop-type heat pipe of the present disclosure. The loop-type heat pipe 100 comprises an evaporator 60, a steam pipe 61, a condenser 62, and a liquid pipe 63 connected in this order to form a loop.

The evaporator has a function of vaporizing a working fluid.

Furthermore, the evaporator is preferably installed in the vicinity of a heat source such as a heating element. In particular, it is preferable that the side of the interior of the evaporator which includes the metal wall to which the porous metal film is directly connected be installed in the vicinity of a heat source such as a heating element. For example, the heating element 64 contacts the outer side of the side of the evaporator 60 which includes the metal wall 13 to which the porous metal film 22 is directly connected, as shown in FIG. 5.

Note that the structure of the interior of the evaporator is as described above, and an explanation thereof has been omitted.

The working fluid vaporized by the evaporator (i.e., steam) is guided to the condenser via the steam pipe.

The condenser has a function of cooling and condensing steam. Furthermore, in order to enhance the cooling effect, a fan may optionally be provided in the vicinity of the condenser. For example, a fan 65 may be installed in the vicinity of the condenser 62, as shown in FIG. 5.

Thereafter, the working fluid condensed by the condenser is guided back to the evaporator via the liquid pipe.

Since the evaporator according to the present disclosure, which can improve heat exchange performance, is used, the performance of the loop-type heat pipe can be remarkably improved.

EXAMPLES

The present disclosure will be described in further detail referring to the Examples shown below. However, the scope of the present disclosure is not limited by the Examples.

(Examples 1 to 6)

In each of the Examples, a composite film was formed by simultaneously spraying an aerosol comprising copper particles (Cu) and an aerosol comprising polymethyl methacrylate particles onto a copper substrate. Note that the average particle diameters of the copper particles and the average particle diameters of the polymethyl methacrylate particles used in the Examples are shown in Table 1.

Thereafter, firing of the formed composite films and removal of the polymethyl methacrylate were performed to form porous metal films on the copper substrates. The firing of the composite films and the removal of the polymethyl methacrylate particles were performed by means of a heat treatment at about 400 °C for three hours in a vacuum. Note that in each of the Examples, the presence or absence of a concave-convex structure on the skeleton of the porous metal film was controlled by appropriately changing the temperature and duration of the heat treatment. For example, by performing firing at 400 °C, a concave-convex structure could be imparted to the skeleton of the porous metal film. Conversely, by performing firing at a high temperature of 700 °C, the concave-convex structure could be eliminated from the skeleton of the porous metal film.

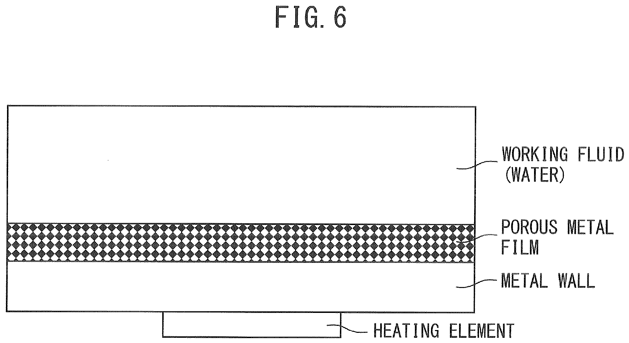

Based on the evaluation model of the Examples and the Comparative Examples shown in FIG. 6, the copper substrates (corresponding to metal walls) and porous metal film formed on the copper substrates used as described above were produced as samples of Examples 1 to 6 and Comparative Examples 1 to 9, which are described later, and the following measurements and evaluations were performed.

In the evaluation model, water is used as the working fluid. Furthermore, the porous metal films of the Examples and the Comparative Examples were produced so that the film thickness were all identical (100 $\mu$m).

<Scanning Electron Microscope (SEM) Imaging>

Cross-sections of the metal walls and the porous metal films of Examples 1 to 6, and the surfaces of the respective porous metal films were imaged using a scanning electron microscope (SEM) and observed.

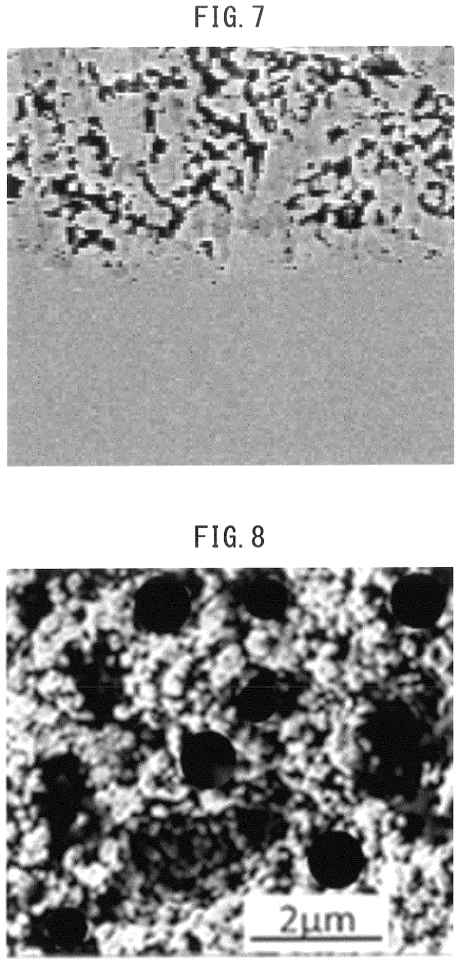

FIG. 7 is an image of the cross-sections of the porous metal film and the metal wall of Example 1 captured using an SEM. As shown in FIG. 7, there was no second phase (phase other than the porous metal film and the metal wall) at the interface between the porous metal film (upper part) and the metal wall (lower part), and it is obvious that the porous metal film and the metal wall were directly connected. Note that though not illustrated, in the SEM images of the cross-sections of the porous metal films and metal walls of Examples 2 to 6, the porous metal films and the metal walls were directly connected, as in the case of Example 1.

Furthermore, FIG. 8 is an image of the surface of the porous metal film of Example 1 captured using an SEM. As shown in FIG. 8, a plurality of communication holes were present in the surface of the skeleton of the porous metal film. Furthermore, it was observed that the skeleton of the porous metal film had a concave-convex structure in which metal particles were joined together. Note that though not illustrated, in the SEM images of the surfaces of the porous metal films of Examples 2 to 6, a plurality of communication holes were present, as in the case of Example 1. Furthermore, the observation results of the presence or absence of a concave-convex structure on the skeletons of the porous metal films of the Examples are shown in Table 1.

<Measurement of Average Pore Size of Communication Holes>

Using the porosimeter described below, the average pore sizes of the communication holes of the porous metal films of the Examples were measured. The results are shown in Table 1.

More specifically, using a porosimeter (injection method-type, manufactured by Porous Materials Corp.), water was injected into the pores of the communication holes of the porous metal film, and the pressure imparted to the water and the weight of the water injected into the pores by the pressure was measured.

The volume of the water was determined from the weight of the water injected into the pores. The volume of the water determined in this manner is equal to the volume of the communication holes. The pressure imparted to the water and the pore size of the communication holes satisfied the following Formula (1) (Washburn's equation).

$$D = -4\sigma\cos\theta/P (1)$$

wherein D represents the pore size (diameter) of the communication holes, $\sigma$ represents the surface tension of water, $\theta$ represents the contact angle between the water and the surface of the communication holes, and P represents the pressure imparted to the water.

The volume of water injected into the communication holes was determined for each pressure p1, p2, ..., and pi. Furthermore, the pore sizes for each pressure were determined from Formula (1). The volume average pore size v of the communication holes was determined from Formula (2) below using the determined volumes v1, v2, ..., and vi of water and the determined pore sizes d1, d2, ..., and di for each pressure p1, p2, ..., and pi. The value of the volume average pore size mv of the communication holes is referred to as the "average pore size of the communication holes" in the present disclosure.

$$mv = (v1 \cdot d1 + v2 \cdot d2 + ... + vi \cdot di) / (v1 + v2 + ... + vi) = \{\sum(vi \cdot di)\} / \{\sum(vi)\} \qquad (2)$$

<Measurement of Porosity of Porous Metal Film>

Using the method described below, the porosity of the porous metal films of the Examples were measured. The results are shown in Table 1.

More specifically, the bulk volumes of the porous metal films were measured, and along with the volume of water injected into the communication holes, the porosities of the porous metal films were determined using Formula (3) below.

$$Po = Vtot / Vb \quad (3)$$

wherein Po represents the porosity of the porous metal film, Vtot represents the volume of water injected, and Vb represents the bulk volume of the porous metal film. Furthermore, Vb = Vp - Vm - Vs, wherein Vp represents the cell volume, Vm represents the volume of water entering the cells housing the porous metal film when no pressure is applied, and Vs represents the volume of the metal substrate (metal wall).

<Measurement of Heat Transfer Coefficient>

In the evaluation model shown in FIG. 6, the temperature difference (degree of superheating) between the metal substrate (metal wall) and the evaporation temperature of water as the working fluid was set to 12 K, and the heat transfer coefficients of the Examples and the Comparative Examples were measured.

(Comparative Example 1)

The sample of Comparative Example 1 was produced in the same manner as Example 1 except that the metal particles and pore-forming-material particles shown in Table 1 were changed to those shown in the row "Comparative Example 1". Thereafter, the same measurements and evaluations as in the Examples were performed. The results are shown in Table 1.

(Comparative Examples 2 and 3)

The samples of Comparative Examples 2 and 3 were produced in the same manner as Example 2 except that the metal particles and pore-forming-material particles shown in Table 1 were changed to those shown in the rows "Comparative Example 2" and "Comparative Example 3", respectively. Thereafter, the same measurements and evaluations as in the Examples were performed for the samples of Comparative Examples 2 and 3. The results are shown in Table 1.

(Comparative Examples 4 to 7)

The samples of Comparative Examples 4 to 7 were produced by integrally sintering copper particles onto copper substrates. Note that the average particle diameters of the copper particles used in the Comparative Examples are shown in Table 1. Thereafter, the same measurements and evaluations as in the Examples were performed for the samples of Comparative Examples 4 to 7. The results are shown in Table 1.

(Comparative Example 8)

The sample of Comparative Example 8 was produced using only a copper substrate (metal wall) without forming a porous metal film. Thereafter, the same measurements and evaluations in the Examples were performed for the sample of Comparative Example 8. The results are shown in Table 1.

(Comparative Example 9)

The sample of Comparative Example 9 was produced by applying a copper foam plating onto a copper substrate. Thereafter, the same measurements and evaluations as in the Examples were performed for the sample of Comparative Example 9. The results are shown in Table 1.

Table 1

| | Porous Metal Film | | | | | | | | | | |
| | Metal Particles | | Hole-Forming-Material | | Weight Ratio of Metal Particles and Hole-Forming-Material (Metal Particles : Hole-Forming-Material) | Firing Conditions | | Forming of Porous Metal Film | Presence/Absence of Concave-Convex Structure | Communication Hole Average Pore Diameter (μm) | Porosity (%) | Heat Transfer Coefficient (kW/(m²K)) |
| | Type | Average Particle Size (μm) | Type | Average Particle Size (μm) | | Temp. (°C) | Time (h) | | | | | |
|---|---|---|---|---|---|---|---|---|---|---|---|---|
| Example 1 | Cu | 0.2 | PMMA | 2 | 75:25 | 400 | 3 | Yes | Present | 2 | 70 | 180 |
| Example 2 | Cu | 0.2 | PMMA | 2 | 85:15 | 700 | 3 | Yes | Absent | 2 | 60 | 120 |
| Example 3 | Cu | 0.2 | PMMA | 5 | 75:25 | 400 | 3 | Yes | Present | 5 | 75 | 240 |
| Example 4 | Cu | 1 | PMMA | 5 | 70:30 | 400 | 3 | Yes | Absent | 5 | 70 | 140 |
| Example 5 | Cu | 0.2 | PMMA | 5 | 80:20 | 400 | 3 | Yes | Present | 5 | 65 | 200 |
| Example 6 | Cu | 0.2 | PMMA | 8 | 85:15 | 400 | 3 | Yes | Present | 8 | 60 | 230 |
| Comp. Ex. 1 | Cu | 0.2 | PMMA | 12 | 85:15 | 400 | 3 | Yes | Present | 12 | 60 | 50 |
| Comp. Ex. 2 | Cu | 1 | PMMA | 50 | 70:30 | 400 | 3 | No | Absent | - | - | - |
| Comp. Ex. 3 | Cu | 20 | PMMA | 5 | 70:30 | 400 | 3 | No | Absent | - | - | - |
| Comp. Ex. 4 | Cu | 2 | - | - | - | 700 | 0.5 | Yes | Absent | 1 | 30 | 40 |
| Comp. Ex. 5 | Cu | 50 | - | - | - | 700 | 0.5 | Yes | Absent | 5 | 40 | 55 |
| Comp. Ex. 6 | Cu | 150 | - | - | - | 750 | 0.5 | Yes | Absent | 100 | 40 | 30 |

(continued)

| | Porous Metal Film | | | | | | | | | | | Heat Transfer Coefficient (kW/(m²K)) |
|---|---|---|---|---|---|---|---|---|---|---|---|---|
| | Metal Particles | | Hole-Forming-Material | | Weight Ratio of Metal Particles and Hole-Forming-Material (Metal Particles : Hole-Forming-Material) | Firing Conditions | | Forming of Porous Metal Film | Presence/ Absence of Concave-Convex Structure | Communication Hole Average Pore Diameter (μm) | Porosity (%) | |
| | Type | Average Particle Size (μm) | Type | Average Particle Size (μm) | | Temp. (°C) | Time (h) | | | | | |
| Comp. Ex. 7 | Cu | 1 | - | - | - | 700 | 0.5 | No | Absent | - | - | - |
| Comp. Ex. 8 | - | - | - | - | - | | - | No | Absent | - | - | 30 |
| Comp. Ex. 9 | Copper Foam Plating | | | | | | | Yes | Absent | 20 | 65 | - |

<Evaluation Results>

As shown in Table 1, it could be understood that the porous metal films according to the present disclosure (Examples 1 to 6) all had high heat transfer coefficients.

Compared to the present disclosure, Comparative Examples 1, and 4 to 6 all exhibited low heat transfer coefficients, and these heat transfer coefficients were found to be comparable to the heat transfer coefficient of Comparative Example 8, in which a porous metal film was not formed. Furthermore, in Comparative Examples 2, 3, and 7, a porous metal film could not be formed on the substrate. In Comparative Example 9, though a porous metal film was formed, the strength thereof was poor, and the heat transfer coefficient could not be measured.

REFERENCE SIGNS LIST

| | |
|---|---|
| 1a, 1b | nozzle |
| 2a | first aerosol |
| 3a | second aerosol |
| 10, 11, 13 | metal wall |
| 12 | metal substrate |
| 20, 21, 22 | porous metal film |
| 22a | composite film |
| 21a, 21b, 21c, 21d, 21e, 21f, 21g | communication hole |
| 21h, 21i, 21j, 21k | communication hole |
| 50,60 | evaporator |
| 61 | steam pipe |
| 62 | condenser |
| 63 | liquid pipe |
| 64 | heating element |
| 65 | fan |
| 100 | loop-type heat pipe |

**Claims**

1. A method for producing an evaporator (50) comprising a metal wall (10) and a porous metal film (20) which is directly connected to the metal wall, the method comprising the steps of:

   (a) simultaneously spraying an aerosol (2a) comprising metal particles (2) from a nozzle (1a) and an aerosol (3a) comprising pore-forming-material particles (3) from another nozzle (1b) onto a metal substrate (12) to form a composite film (22a) on the metal substrate, and
   (b) firing the composite film to form the porous metal film.

2. The method according to claim 1, wherein the pore-forming-material particles are dielectric particles having electrification characteristics.

3. The method according to claim 1 or 2, wherein the metal particles are copper particles.

4. The method according to any one of claims 1 to 3, wherein the pore-forming-material particles are polymethyl methacrylate particles.

**Patentansprüche**

1. Verfahren zur Herstellung eines Verdampfers (50), der eine Metallwand (10) und einen porösen Metallfilm (20) umfasst, der direkt mit der Metallwand verbunden ist, wobei das Verfahren folgende Schritte umfasst:

   (a) gleichzeitiges Aufsprühen eines Metallpartikel (2) umfassenden Aerosols (2a) aus einer Düse (1a) und eines porenbildende Materialpartikel (3) umfassenden Aerosols (3a) aus einer anderen Düse (1b) auf ein Metallsubstrat (12) zur Bildung eines Verbundfilms (22a) auf dem Metallsubstrat, und
(b) Brennen des Verbundfilms zur Bildung des porösen Metallfilms.

2. Verfahren nach Anspruch 1, wobei die Partikel des porenbildenden Materials dielektrische Partikel sind, die Elektrifizierungseigenschaften aufweisen.

3. Verfahren nach Anspruch 1 oder 2, wobei die Metallpartikel Kupferpartikel sind.

4. Verfahren nach einem der Ansprüche 1 bis 3, wobei die porenbildenden Materialpartikel Polymethylmethacrylatpartikel sind.


**Revendications**

1. Procédé pour produire un évaporateur (50) comprenant une paroi métallique (10) et un film métallique poreux (20) qui est directement relié à la paroi métallique, le procédé comprenant les étapes de :

   (a) la pulvérisation simultanée d'un aérosol (2a), comprenant des particules métalliques (2), à partir d'une buse (1a), et d'un aérosol (3a), comprenant des particules de matériau porogène (3), à partir d'une autre buse (1b), sur un substrat métallique (12) pour former un film composite (22a) sur le substrat métallique, et
   (b) la cuisson du film composite pour former le film métallique poreux.

2. Procédé selon la revendication 1, dans lequel les particules de matériau porogène sont des particules diélectriques ayant des caractéristiques d'électrification.

3. Procédé selon la revendication 1 ou 2, dans lequel les particules métalliques sont des particules de cuivre.

4. Procédé selon l'une quelconque des revendications 1 à 3, dans lequel les particules de matériau porogène sont des particules de méthacrylate de polyméthyle.

FIG. 1

FIG. 2

EP 3 620 246 B1

FIG. 3

20

FIG. 4

# FIG. 5

FIG. 6

WORKING FLUID
(WATER)

POROUS METAL
FILM

METAL WALL

HEATING ELEMENT

## FIG. 7

## FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000049266 A
- JP 2003208901 A
- JP 2011044653 A
- JP 2002118195 A
- JP 2003293166 A
- US 3753757 A